Europäisches Patentamt

European Patent Office

Office européen des brevets

(11) Veröffentlichungsnummer: **0 218 039**
**B1**

(19)

(12) **EUROPÄISCHE PATENTSCHRIFT**

(45) Veröffentlichungstag der Patentschrift:
07.11.90

(51) Int. Cl.⁵: **H01L 21/31**

(21) Anmeldenummer: 86110942.9

(22) Anmeldetag: 07.08.86

(54) Verfahren zur Übertragung feinster Fotolackstrukturen.

(30) Priorität: 30.09.85 DE 3534834

(43) Veröffentlichungstag der Anmeldung:
15.04.87 Patentblatt 87/16

(45) Bekanntmachung des Hinweises auf die Patenterteilung:
07.11.90 Patentblatt 90/45

(84) Benannte Vertragsstaaten:
DE FR GB

(73) Patentinhaber: Siemens Aktiengesellschaft,
Wittelsbacherplatz 2, D-8000 München 2(DE)

(72) Erfinder: Reichert, Hans, Dr. Dipl.-Phys.,
Weissenseestrasse 83, D-8000 München 90(DE)

(56) Entgegenhaltungen:
DE-A- 2 748 401

JOURNAL OF THE ELECTROCHEMICAL SOCIETY,
Band 128, Nr. 3, März 1981, Seiten 617-619, Manchester,
New Hampshire, US; J. GÖTZLICH et al.: "Tapered
windows in SIO2, SI3N4, and polysilicon layers by ion
implantation"
IEEE TRANSACTIONS ON ELECTRON DEVICES, Band
ED-26, Nr. 4, April 1979, Seiten 604-610, IEEE, New York,
US; H. SHIBATA et al.: "A new fabrication method of
small-dimension devices-multiple-wall self-aligned
devices"
IBM TECHNICAL DISCLOSURE BULLETIN, Band 24,
Nr. 11B, April 1982, Seite 6094, New York, US; H. HINKEL
et al.: "Method of influencing the etch rate of PECVD
films and applications of the method"

(56) Entgegenhaltungen: (Fortsetzung)
IBM TECHNICAL DISCLOSURE BULLETIN, Band 17,
Nr. 2, Juli 1974, Seite 635, New York, US; V.J. SILVESTRI:
"Selective etching of oxides by ion implantation"

**Beschreibung**

Die Erfindung betrifft ein Verfahren zur Übertragung feinster Fotolackstrukturen in eine dielektrische Schicht nach dem Oberbegriff des Anspruchs 1. Ein solches Verfahren ist aus DE-A 2 748 401 bekannt. Bei diesem bekannten Verfahren wird auf einer Isolierschicht eine Fotolackmaske aufgebracht und dann die Isolierschicht mit Ionen geringer Energie bombadiert, wodurch die Isolierschicht rascher geätzt werden kann. Die Energie der Ionen ist dabei so gering, daß die meisten Ionen eine obere Isolierschicht nicht durchdringen. Bei diesem bekannten Verfahren erfolgt praktisch keine seitliche Unterätzung. Bei diesem bekannten Verfahren wird eine Siliziumnitridschicht geschädigt und anschließend geätzt.

Bei der Herstellung von Halbleiterbauelementen müssen in einer dielektrischen Schicht extreme Feinstrukturen mit kleinsten Strukturabmessungen in der Größenordnung von 0,1 μm erzeugt werden. Zu diesem Zweck wird üblicherweise auf die zu strukturierende dieleketrische Schicht eine Fotolackmaske aufgebracht. Die Strukturen der Fotolackmaske sollen sodann geometriegetreu auf die zu strukturierende dielektrische Schicht übertragen werden. Häufig werden als zu strukturierende dielektrische Schicht eine Oxidschicht und/oder eine Nitridschicht verwendet.

Bei bisher bekannten Verfahren zur Übertragung feinster Fotolackstrukturen in eine dielektrische Schicht wird die Geometrietreue der auf die geätzte dielektrische Schicht übertragenen Struktur durch eine schlechte Haftung des Fotolacks auf der dielektrischen Schicht ungünstig beeinflußt. Bei bekannten Verfahren zur Übertragung feinster Fotolackstrukturen in eine dielektrische Schicht ist die Breite der seitlichen Unterätzung selbst bei idealer Haftung des Fotolacks auf der dielektrischen Schicht gleich der Dicke der geätzten dielektrischen Schicht.

Bei bisher bekannten Verfahren zur Übertragung feinster Fotolackstrukturen wurden möglichst schmale Streifen in der Fotolackstruktur auf die zu strukturierende dielektrische Schicht abgebildet. Diese möglichst schmalen Streifen bei bekannten Verfahren zur Übertragung feinster Fotolackstrukturen sind jedoch für Mikrowellentransistoren immer noch zu breit. Durch Ausheizen der Fotolackmaske bei Temperaturen von 100 °C bis zu 140 °C verkleinern sich die auf die zu strukturierende dielektrische Schicht abzubildenden Streifenbreiten in der Struktur der Fotolackmaske dadurch, daß die Kantenbereiche der Fotolackmaske zusammenlaufen. Dieser Vorgang des Zusammenlaufens der Kantenbereiche der Fotolackmaske muß bei der gewünschten Streifenbreite in der Struktur der Fotolackmaske abgebrochen werden. Die Geschwindigkeit des Lacklaufens ist jedoch nicht vorherbestimmbar. Daher sind während des Lacklaufens mehrfache Unterbrechungen mit optischer Kontrolle der Streifenbreiten in der Struktur der Fotolackmasken auf den Halbleiterwafern nötig. Wird während des Lacklaufens die gewünschte Streifenbreite in der Struktur der Fotolackmaske unterschritten, muß die Fototechnik, bei der die Fotolackmaske strukturiert wird, wiederholt werden.

Das Lacklaufen zur Verkleinerung der Streifenbreite in der Struktur der Fotolackmaske auf einem Halbleiterwafer erfolgt räumlich nicht gleichmäßig. Daher müssen bei der Herstellung von Halbleiterbauelementen bei Verwendung eines bekannten Verfahrens zur Übertragung feinster Fotolackstrukturen große Fertigungstoleranzen in Kauf genommen werden.

Der vorliegenden Erfindung liegt die Aufgabe zugrunde, ein Verfahren der eingangs genannten Art anzugeben, mit der eine geometriegetreue Übertragung feinster Fotolackstrukturen in eine dielektrische Schicht bei geringen Fertigungstoleranzen möglich ist.

Diese Aufgabe wird durch ein Verfahren nach dem Anspruch 1 gelöst.

Die Erfindung ermöglicht folgende Vorteile:

Eine schlechte Fotolackhaftung auf einer zu strukturierenden dielektrischen Schicht, wie sie bei konventionellen Verfahren die Geometrietreue der geätzten dielektrischen Schicht ungünstig beeinflußt, spielt bei einem Verfahren nach der Erfindung keine Rolle.

Die seitliche Unterätzung, die bei einem konventionellen Verfahren selbst bei idealer Lackhaftung auf einer zu strukturierenden dielektrischen Schicht mindestens gleich der Dicke der geätzten Schicht ist, kann deutlich unter diesen Wert reduziert werden.

Die Implantation mit schräg auf eine Halbleiterscheibe auftreffendem Ionenstrahl führt bei geeigneter Orientierung der Lackkante relativ zum Ionenstrahl zu einer Abschattung. Die Streifenbreite in der zu strukturierenden dielektrischen Schicht fällt dabei schmäler aus, als die bei der Schattenabbildung auf die zu strukturierende dielektrische Schicht abgebildete Streifenbreite der Fotolackstruktur.

Diese drei genannten Vorteile ermöglichen es, daß bei der Herstellung von Mikrowellentransistoren, bei denen Streifenbreiten im Submikron-Bereich gefordert sind, noch die konventionelle Fototechnik eingesetzt wird. Mit einem Verfahren nach der Erfindung lassen sich auch solche Streifenbreiten auf einer zu strukturierenden dielektrischen Schicht noch sicher fertigen, die bereits unter der gerade noch abbildbaren Streifenbreite in der Struktur der Fotolackmasken liegen.

Weitere Vorteile und Ausgestaltungen der Erfindung sind in Unteransprüchen, der Beschreibung und der Zeichnung dargestellt.

Ausführungsbeispiele werden anhand der Zeichnung näher erläutert.

Fig. 1 erklärt das Strukturieren gemäß der Erfindung einer Siliziumnitridschicht mit dünner Oxidauflage.

Fig. 2 erläutert die Strukturierung einer reinen Oxid- bzw. Nitridschicht.

Fig. 3 erläutert die Strukturierung gemäß der Erfindung einer dielektrischen Schicht mit Ausnutzung der Abschattung an einer Lackkante zur weiteren Reduktion der Strukturbreite.

Bei allen Verfahren wird eine Lackmaske 1 wie für die konventionelle Ätztechnik erzeugt. Diese Maske 1 dient zur Maskierung der nachfolgenden Ionenimplantation. Die Ionenimplantation wird so geführt, daß weder die Lackmaske 1 noch die jeweils zu strukturierende Schicht 2 bis 6 vom auftreffenden Ionenstrahl durchdrungen werden. Die Transmission des auf die Lackmaske 1 und auf die Teilbereiche 8, 11, 13, 15, 17 der zu strukturierenden dielektrischen Schicht 2 bis 6 auftreffenden Ionenstrahls soll kleiner als $10^{-5}$ sein. Dabei erfolgt weder eine Dotierung des Halbleiterkristalls 7 noch eine Dotierung der jeweils zu strukturierenden dielektrischen Schicht 2 bis 6, soweit sich die jeweils zu strukturierende dielektrische Schicht unterhalb des Lacks 1 befindet.

Je nach zu bearbeitender dielektrischer Schicht ergeben sich verschiedene Möglichkeiten der Ausgestaltung des Verfahrens.

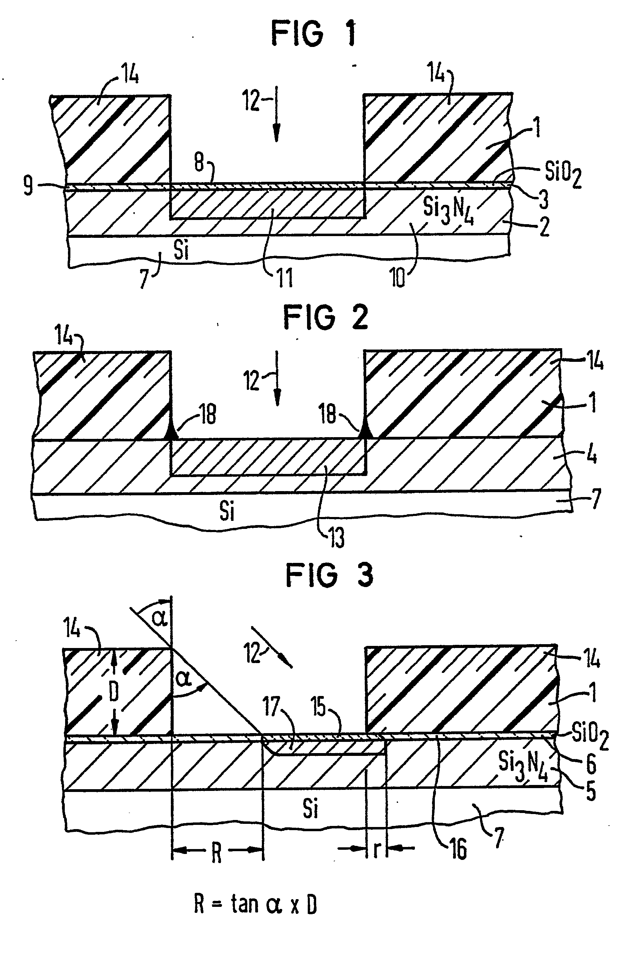

Fig. 1 erläutert die Strukturierung einer Siliciumnitridschicht 2 mit einer dünnen Oxidauflage 3. Die Nitridschicht 2 wird durch thermische Oxidation oberflächig in eine Siliciumdioxidschicht 3 umgewandelt. Die Dicke der Oxidschicht 3 liegt zwischen 2 nm und 5 nm. Die Oxidschicht 3 verhindert sicher einen Ätzangriff des darunterliegenden Nitrids 2 in heißer Phosphorsäure. Heiße Phosphorsäure ist das Standardätzmittel für Siliciumnitrid.

In den lackfreien Bereichen wird durch die Implantation das Oxid 8 durch den Ionenstrahl 12 so geschädigt und chemisch verändert, daß dieses Oxid 8 in heißer Phosphorsäure leicht ätzbar wird. Nach der Implantation des Oxids 8 ist die Fotolackmaske 1 überflüssig. Die Fotolackmaske 1 kann ohne Schaden vor der Phosphorsäureätzung abgelöst werden. Das geschädigte Oxid 8 wird selektiv in der Phosphorsäure geätzt. Der nicht geschädigte Bereich 9 des Oxids wird von der Phosphorsäure nicht geätzt und bleibt erhalten. Vorteilhaft ist das Nitrid 11 im implantierten Bereich ebenfalls durch den Ionenstrahl 12 geschädigt und dadurch wesentlich schneller ätzbar als das ungeschädigte Nitrid 10 außerhalb des lackfreien Bereichs. Infolge dieser Ätzanisotropie zwischen der geschädigten Nitridschicht 11 und der nicht geschädigten Nitridschicht 10 ergeben sich insgesamt kürzere Ätzzeiten als sie beim normalen Verfahren nötig sind. Beim normalen Verfahren wäre das Nitrid 11 nicht durch eine Implantation geschädigt und wäre infolgedessen nicht schneller ätzbar als das ungeschädigte Nitrid 10. Bei Versuchen konnte die Gesamtätzzeit gegenüber der Ätzzeit gleicher Schichtdicke in konventioneller Technik halbiert werden. Entsprechend halbiert war auch die unerwünschte seitliche Unterätzung im Bereich der Nitridschicht 2.

Fig. 2 erläutert die Strukturierung einer reinen Oxid- bzw. Nitridschicht 4. Ein zum anhand von Fig. 1 erläuterten Verfahren analoges Ergebnis läßt sich auch bei einer reinen Oxid- bzw. Nitridschicht 4 erzielen, die allerdings nicht unter das beanspruchte Verfahren fällt ohne daß eine dünne Deckschicht aufgebracht bzw. erzeugt und sodann durch Implantation selektiv ätzbar gemacht werden müßte. Durch Implantation wird der Fotolack 1 an der Lackkante 18 gewissermaßen mit der dielektrischen Schicht 4 verschweißt. An den Kanten 18 entsteht eine ideale Lackhaftung auf der Schicht 4. Das Dielektrikum 4 ist im implantierten Bereich 13 ebenfalls leichter ätzbar als im nicht implantierten Bereich. Infolge dieser Ätzanisotropie läßt sich analog zu dem anhand von Fig. 1 geschilderten Verfahren auf die gleiche Weise die Unterätzung innerhalb der Schicht 4 reduzieren. Infolge der Ionenimplantation ist wiederum der Bereich 13 der Siliciumdioxid (SiO₂)- bzw. Siliciumnitrid (Si₃N₄)-Schicht geschädigt worden und dadurch mit einer stark erhöhten Ätzbarkeit im Vergleich zum nicht durch Ionenimplantation geschädigten Bereich der Schicht 4 versehen worden.

Bei allen Ausführungsbeispielen läßt sich erkennen, daß der Fotolack 1 infolge der Implantation im oberen Bereich 14 ebenfalls dotiert ist.

Fig. 3 erläutert die Strukturierung einer dielektrischen Schicht mit Ausnutzung der Abschattung an einer Lackkante zur weiteren Reduktion der Streifenbreite. Bei schräg einfallendem Ionenstrahl 12 ergibt sich nach Fig. 3 eine weitere Reduzierung der Streifenbreite um den Betrag R mit

$$R = D \cdot \tan \alpha$$

Dabei besitzt die Fotolackmaske 1 die Dicke D und ist der Ionenstrahl 12 gegenüber dem Lot auf die dielektrische Schicht um den Winkel $\alpha$ geneigt. Dieser theoretische Wert R für die Reduzierung der Streifenbreite durch Schattenwurf wird wegen der Unterimplantation an der Gegenkante nicht ganz erreicht. An der Gegenkante dringen Ionen auch in den Fotolack 1 ein und können teilweise durch den Fotolack 1 hindurch innerhalb eines Bereichs r in das unter dem Fotolack 1 liegende Dielektrikum 5, 6 eindringen. Im Bereich 15 ist das Dielektrikum durch den schräg einfallenden Ionenstrahl 12 geschädigt und wiederum erheblich leichter ätzbar als der nicht geschädigte Bereich des Dielektrikums 5, 6.

Wenn wie in Fig. 1 beschrieben, eine dünne Oxidauflage eine Nitridschicht im nicht geschädigten Bereich gegen Phosphorsäureätzung schützen soll, ist es wegen der Unterimplantation im Bereich r in Fig. 3 vorteilhaft, die Lackmaske vor der Ätzung mit heißer Phosphorsäure nicht zu entfernen, da auf diese Weise eine zu erwartende Unterätzung im Bereich r räumlich eingeschränkt werden kann.

## Patentansprüche

1. Verfahren zur Übertragung von Fotolackstrukturen in eine dielektrische Schicht (2 bia 6), bei dem auf der dielektrischen Schicht (3, 4, 6) eine Fotolackmaske (1) erzeugt wird, bei dem diese Fotolackmaske (1) zur Maskierung einer nachfolgenden Ionenimplantation dient, dadurch gekennzeichnet, daß zur Übertragung feinster Fotolackstrukturen in die dielektrische Schicht (2, 3, 5, 6) eine zu strukturierende Silizium-Nitridschicht (2) oberflächig mit einer dünnen, thermisch erzeugten Oxidschicht (3) versehen wird, die einen Ätzangriff der darunterliegenden Nitridschicht (2) in heißer Phosphorsäure verhindert, daß die nachfolgende Ionenimplantation so geführt wird, daß weder die Lackmaske (1) noch die zu strukturierende dielektrische Schicht (2, 3, 5, 6) vom auftreffenden Ionenstrahl (12) durchdrun-

gen wird, daß Teilbereiche (8) des Oxids durch die Implantation durch den Ionenstrahl (12) so geschädigt und chemisch verändert werden, daß diese Teilbereiche (8) des Oxids (3) in heißer Phosphorsäure leicht ätzbar werden, daß die geschädigten Teilbereiche (8) des Oxids (3) selektiv in Phosphorsäure geätzt werden, und daß anschließend das nach Ätzung der geschädigten Teilbereiche (8) des Oxids (3) freiliegende Nitrid (11) geätzt wird.

2. Verfahren nach Anspruch 1, dadurch gekennzeichnet, daß die Transmission des auf die Lackmaske (1) und auf Teilbereiche (8, 11, 15, 17) der zu strukturierenden dielektrischen Schicht (2, 3, 5, 6) auftreffenden Ionenstrahls (12) weniger als $10^{-5}$ beträgt.

3. Verfahren nach Anspruch 1 oder 2, dadurch gekennzeichnet, daß bei der Ionenimplantation auch das unter dem geschädigten Bereich (8) des Oxids (3) liegende Nitrid (11) geschädigt wird.

4. Verfahren nach einem der Ansprüche 1 bis 3, dadurch gekennzeichnet, daß die Teilbereiche (15, 17) der zu strukturierenden dielektrischen Schicht (5, 6) durch einen schräg einfallenden Ionenstrahl (12) geschädigt wird.

5. Verfahren nach Anspruch 4, dadurch gekennzeichnet, daß die Fotolackmaske (1) erst nach Ätzung der zu strukturierenden dielektrischen Schicht (15, 17) entfernt wird.

## Claims

1. Method for transferring photoresist structures into a dielectric layer (2 to 6), in which a photoresist mask (1) is produced on the dielectric layer (3, 4, 6), in which this photoresist mask (1) serves for masking a subsequent ion implantation, characterized in that, for transferring superfine photoresist structures into the dielectric layer (2 to 6), a silicon nitride layer (2) to be structured is provided superficially with a thin, thermally-generated oxide layer (3) which prevents an etching attack on the nitride layer (2) beneath in hot phosphoric acid, in that the subsequent ion implantation is controlled in such a way that neither the resist mask (1) nor the dielectric layer (2 to 6) to be structured are penetrated by the incident ion beam (12), in that partial regions (8) of the oxide are damaged and chemically changed by the implementation by means of the ion beam (12) so as to make these partial regions (8) of the oxide (3) readily etchable in hot phosphoric acid, in that the damaged partial regions (8) of the oxide (3) are selectively etched in phosphoric acid, and in that subsequently after etching of the partial regions (8) of the oxide (3), the exposed nitride (11) is etched.

2. Method according to Claim 1, characterized in that the transmission intensity of the ion beam (12) impinging upon the resist mask (1) and on partial regions (8, 11, 15, 17) of the dielectric layer (2 to 6) to be structured is less than $10^{-5}$.

3. Method according to Claim 1 or 2, characterized in that, during the ion implantation, the nitride (11) lying below the damaged region (8) of the oxide (3) is also damaged.

4. Method according to one of Claims 1 to 3, characterized in that the partial regions (15, 17) of the dielectric layer (5, 6) to be structured are damaged by an obliquely incident ion beam (12).

5. Method according to Claim 4 characterized in that the photoresist mask (1) is only removed after the etching of the dielectric layer (15, 17) to be structured.

## Revendications

1. Procédé pour transférer des structures en une laque photosensible dans une couche diélectrique (2 à 6), du type dans lequel on produit sur la couche diélectrique (3, 4, 6) un masque en une laque photosensible (1) sert à masquer une post-implantation d'ions, caractérisé par le fait que pour le transfert des structures les plus fines en une laque photosensible dans la couche diélectrique (2 à 6), on pourvoit la surface d'une couche de nitrure de silicium (2) d'une mince couche d'oxyde (3) produite par voie thermique qui empêche une attaque de la couche de nitrure sous-jacente (2) dans de l'acide phosphorique chaud, que la post-implantation d'ions est menée de telle façon que ni le masque en la laque (1) ni la couche diélectrique à structurer (2 à 6) ne soient traversées par le faisceau ionique incident, que des zones partielles (8) de l'oxyde (3) sont endommagées et modifiées chimiquement de telle façon par l'implantation par le faisceau ionique (12), que ces zones partielles (8) de l'oxyde (3) sont rendues facilement attaquables par de l'acide phosphorique chaud, que les zones partielles endommagées (8) de l'oxyde (3) sont attaquées sélectivement par l'acide phosphorique et qu'ensuite le nitrure (11) qui est dégagé après l'attaque des zones partielles endommagées (8) de l'oxyde (3), est attaqué.

2. Procédé selon la revendication 1, caractérisé par le fait que la transmission du faisceau ionique (12) qui incide sur le masque de laque (1) et sur des zones partielles (8, 11, 15, 17) de la couche diélectrique (2, 6) à structurer, est inférieur à $10^{-5}$.

3. Procédé selon la revendication 1 ou 2, caractérisé par le fait que lors de l'implantation d'ions, le nitrure (11) qui se trouve en-dessous de la zone endommagée (8) de l'oxyde, est également endommagé.

4. Procédé selon l'une des revendications 1 à 3, caractérisé par le fait que les zones partielles (15, 17) de la couche diélectrique (5, 6) à structurer, sont endommagées par un faisceau ionique à incidence oblique (12).

5. Procédé selon la revendication 4, caractérisé par le fait que le masque en laque photosensible (1) n'est supprimé qu'après l'attaque de la couche diélectrique à structurer (15, 17).

# FIG 1

# FIG 2

# FIG 3

$$R = \tan \alpha \times D$$